# EUROPÄISCHE PATENTANMELDUNG

(11) **EP 1 973 390 A1**
(43) Veröffentlichungstag der Anmeldung: **24.09.2008**
(21) Anmeldenummer: 07464001.2
(22) Anmeldetag: 20.03.2007
(51) Int. Cl.: H05K 1/00, G01D 11/24

(54) **Elektronisches Bauelement, insbesondere Sensormodul, mit einer elektronischen Schaltung zur Erfassung und/oder Verarbeitung von Daten und Verfahren zu dessen Herstellung**

(71) Anmelder: Continental Automotive GmbH, 30165 Hannover (DE)
(72) Erfinder: Schmidt, Harald, 93055 Regensburg (DE); Tataru, Matei Vergiliu, 220089 Dr. Tr.-Severin (RO)

(57) **Zusammenfassung**

Es wird ein Elektronisches Bauelement (1) mit einer elektronischen Schaltung zur Erfassung und/oder Verarbeitung von Daten beschrieben, das eine einfache und kostengünstige Herstellung ermöglicht. Dieses weist ein erstes Bauteil (10) auf, welches zumindest einen Kontaktstift (14) mit einem ersten, extern kontaktierbaren Ende (15) und einem zweiten Ende (16) umfasst, welches einen ersten Steckkontakt (17) zur Herstellung einer elektrischen Verbindung zu der elektronischen Schaltung ausbildet. Ein zweites Bauteil (30) umfasst die elektronische Schaltung und einen zweiten, zu dem ersten Steckkontakt (17) komplementären Steckkontakt (42). Dieser ist elektrisch mit der elektronischen Schaltung verbunden und wird in einem wannenförmigen Bereich (37, 45) des zweiten Bauteils (30) von zumindest einem Festlager (39, 40) gehaltert. Der erste Steckkontakt (17) ist gabelförmig mit zumindest zwei Schenkeln (18) ausgebildet, so dass der zweite Steckkontakt (42) in einem Zwischenraum (19) zwischen den zumindest zwei Schenkeln (18) angeordnet und kraftschlüssig mit den zumindest zwei Schenkeln (18) verbunden ist, wenn das erste und zweite Bauteil (10, 30) miteinander verbunden sind.

## Beschreibung

Die Erfindung betrifft ein elektronisches Bauelement, insbesondere ein Sensormodul zur Verwendung in Kraftfahrzeugen, mit einer elektronischen Schaltung zur Erfassung und/oder Verarbeitung von Daten sowie ein Verfahren zur Herstellung eines derartigen elektronischen Bauelements.

Die elektronische Schaltung eines solchen Bauelements wird zum Schutz vor mechanischen und/oder elektrischen Einflüssen üblicherweise in einem Gehäuse angeordnet. Dazu kann die elektronische Schaltung auf einem Träger, z.B. einer Leiterplatte aus FR-4 oder einer flexiblen Folie (sog. Flexfolie), aufgebracht werden, welcher mit einer Leiterzugstruktur versehen ist. Der mit der elektronischen Schaltung bestückte Träger wird dann an einem Gehäusebauteil des elektronischen Bauelements angebracht. Zur Aufnahme des bestückten Trägers bzw. der elektronischen Schaltung umfasst das elektronische Bauelement beispielsweise eine Kavität oder einen Aufnahmebereich. Dieser wird optional mit einem Deckel verschlossen.

Es sind z.B. auch solche elektronische Bauelemente bekannt, welche ein erstes, als Stecker ausgebildetes Bauteil mit darin ausgebildeten Kontaktstiften sowie ein zweites, als Deckel ausgebildetes Bauteil aufweisen, wobei das zweite Bauteil die elektronische Schaltung trägt. In jüngerer Zeit haben sich dabei als zweite Bauteile MID (Moulded Interconnected Device) -Bauteile oder Quasi-MID-Bauteile etabliert. MID-Bauteile weisen einen aus einem thermoplastischen Kunststoff im Spritzverfahren gebildeten Grundkörper auf, auf welchem eine Metallisierungsstruktur aufgebracht ist. Ausgangsmaterial bei Quasi-MID-Bauteilen ist eine mit einer Metallisierung versehene Flexfolie, die im Rahmen eines Hinterspritzungs- oder Umspritzungsvorgangs in eine gewünschte dreidimensionale Gestalt gebracht wird. Die Herstellung von MID- bzw. Quasi-MID-Bauteilen ist aus dem Stand der Technik bekannt, so dass an dieser Stelle nicht näher darauf eingegangen wird.

Im Rahmen des Fertigungsvorganges müssen das erste und zweite Bauteil mechanisch und elektrisch miteinander verbunden werden, damit die von der elektronischen Schaltung abgegebenen Signale an die in dem ersten Bauteil ausgebildeten Kontaktstifte angelegt werden können. Über einen Steckverbinder, der mit dem ersten Bauteil verbindbar ist, können diese dann einer Recheneinheit, z.B. einem Steuergerät zur weiteren Verarbeitung, zur Verfügung gestellt werden.

Zur Herstellung der elektrischen Verbindung zwischen den Kontaktstiften in dem ersten Bauteil und der elektronischen Schaltung auf oder in dem zweiten Bauteil sind sog. Pressfit-Verbindungen oder Lötverbindungen bekannt. Pressfit-Verbindungen weisen den Nachteil hoher Herstellungskosten auf. Die Verwendung einer Lötverbindung bedingt, dass der Träger, auf welchem die elektronische Schaltung angeordnet ist, mit einer zweiseitigen Metallisierung versehen sein muss. Auf einer inneren und den Kontaktstiften zugewandten Seite des Trägers sind die Bauelemente der elektronischen Schaltung angeordnet, um diese vor mechanischen und elektrischen Einflüssen zu schützen. Eine Lötverbindung kann jedoch nur von der äußeren Seite her erfolgen, da die Lötverbindung erst nach dem Zusammenfügen von ersten und zweiten Bauteilen hergestellt werden kann. Die Bereitstellung zweiseitig metallisierter Träger, z.B. der eingangs erwähnten Flexfolie, ist jedoch mit hohen Kosten und aufwendigen Fertigungsschritten verbunden.

Es ist daher die Aufgabe der vorliegenden Erfindung, ein elektronisches Bauelement der oben genannten Art anzugeben, welches kostengünstig herstellbar ist und eine dauerhaft zuverlässige elektrische Verbindung zwischen dem ersten und zweiten Bauteil aufweist. Ferner soll ein Verfahren zur Herstellung eines derartigen elektronischen Bauelements angegeben werden, welches im Vergleich zum Stand der Technik mit einer reduzierten Anzahl an Fertigungsschritten auskommt und dabei gleichzeitig die blinde Montage von miteinander zu verbindenden Bauteilen ermöglicht.

Diese Aufgaben werden mit den Merkmalen der unabhängigen Patentansprüche gelöst. Bevorzugte Ausgestaltungen ergeben sich jeweils aus den abhängigen Patentansprüchen.

Ein erfindungsgemäßes elektronisches Bauelement umfasst ein erstes und ein zweites Bauteil. Das erste Bauteil umfasst zumindest einen Kontaktstift mit einem ersten, extern kontaktierbaren Ende und einem zweiten Ende, welches einen ersten Steckkontakt zur Herstellung einer elektrischen Verbindung zu der elektronischen Schaltung ausbildet. Das zweite Bauteil umfasst die elektronische Schaltung und einem zweiten, zu dem ersten Steckkontakt komplementären Steckkontakt, welcher elektrisch mit der elektronischen Schaltung verbunden ist und in einem wannenförmigen Bereich des zweiten Bauteils von zumindest einem Festlager gehaltert wird. Der erste Steckkontakt ist gabelförmig mit zumindest zwei Schenkeln ausgebildet, so dass der zweite Steckkontakt in einem Zwischenraum zwischen den zumindest zwei Schenkeln angeordnet und kraftschlüssig mit den zumindest zwei Schenkeln verbunden ist, wenn das erste und das zweite Bauteil miteinander verbunden sind.

Die erfindungsgemäße Ausgestaltung der Steckkontaktverbindung ermöglicht nunmehr die Verwendung einer lediglich einseitigen Metallisierung des Trägers der elektronischen Schaltung. Der Träger der elektronischen Schaltung kann dabei durch eine Flexfolie, eine Leiterplatte oder einen Abschnitt des Gehäuses des zweiten Bauteils gebildet sein. Hierdurch lassen sich Fertigungskosten reduzieren. Dies resultiert einerseits aus dem konstruktiven Aufbau der Steckverbindung sowie andererseits aus dem Umstand, dass auf eine Lötverbindung verzichtet werden kann. Die Steckverbindung ermöglicht darüber hinaus eine blinde Montage beim Zusammenfügen bzw. Verbinden des ersten und zweiten Bauteils.

Die Steckkontaktverbindung zwischen dem ersten und dem zweiten Steckkontakt stellt eine Abwandlung der sog. Schneid-Klemm-Verbindungen (Insulation Displacement Connection oder Insulation Piercing) dar. Dabei wird ein gabelförmig ausgebildeter Steckkontakt mit zumindest zwei Schenkeln kraftschlüssig mit einem zweiten Steckkontakt verbunden. Der zweite Steckkontakt kann z.B. einen rechteckigen, quaderförmigen, ovalen, runden, polygunalen usw. Querschnitt aufweisen und aus einem Stück Metall gefertigt sein. Um die mechanische Verbindung des ersten und zweiten Steckkontakts zu ermöglichen, ist der zweite Steckkontakt in einem wannenförmigen Bereich angeordnet, in welchen die zumindest zwei Schenkel des ersten Steckkontakts widerstandslos eindringen können. Der wannenförmige Bereich des zweiten Bauteils kann durch eine Vertiefung in einem Gehäuse des zweiten Bauteils ausgebildet sein.

Um eine zuverlässige und blinde Steckverbindung zwischen dem ersten und dem zweiten Steckkontakt zu ermöglichen ist es zweckmäßig, wenn der zweite Steckkontakt kraftschlüssig von dem zumindest einen Festlager gehaltert wird. Besonders bevorzugt ist es hierbei, wenn der zweite Steckkontakt von zwei Festlagern gehaltert wird.

Ein erster Abschnitt des zweiten Steckkontakts ist gemäß einer Ausführungsform in dem wannenförmigen Bereich angeordnet, welcher mit einer Lotpaste gefüllt ist, um eine elektrische Verbindung zwischen dem zweiten Steckkontakt und einem Leiterzugabschnitt herzustellen, welcher sich in den wannenförmigen Bereich hinein erstreckt. Das Einbringen der Lotpaste in den wannenförmigen Bereich kann z.B. durch Rakeln erfolgen. Zweckmäßigerweise erfolgt dies im Rahmen der Herstellung zu einem Zeitpunkt, zu dem Lotpaste auf die Metallisierung des Trägers aufgebracht wird, um in einem anschließenden Verarbeitungsschritt Bauelemente der elektronischen Schaltung auf der metallisierten Seite des Trägers aufzubringen und schließlich zu verlöten.

Ein zweiter, freier Abschnitt des zweiten Steckkontakts wird zweckmäßigerweise durch das zumindest eine Festlager und ein Ende des zweiten Steckkontakts begrenzt, wobei ein Eingriff des gabelförmigen, ersten Steckkontakts mit dem zweiten Steckkontakt in dem zweiten Abschnitt in einer Ausnehmung des zweiten Bauteils erfolgt. Unter einem freien Abschnitt ist ein Abschnitt des zweiten Steckkontakts zu verstehen, der nach Art eines Kragbalkens ausgebildet ist. Dabei erfolgt die Lagerung des zweiten Abschnitts im Bereich des Festlagers. Die Ausnehmung ist benachbart zu dem wannenförmigen Bereich angeordnet und von dieser getrennt. Die Ausnehmung kann auch Bestandteil der wannenförmigen Ausnehmung sein, wobei eine Trennung durch einen Steg oder eine Wandung erfolgt, um einen Bereich vorzusehen, welcher mit Lotpaste gefüllt wird und einen Bereich, welcher frei von Lotpaste bleibt. Durch dieses Vorgehen ist sichergestellt, dass beim und nach dem Verbinden des ersten und zweiten Steckkontakts keine Kraft auf den zweiten Steckkontakt im Bereich der Lötverbindung ausgeübt wird. Dies erhöht die Zuverlässigkeit über die Lebensdauer.

Gemäß einer weiteren Ausführungsform ist das zumindest eine Festlager im Bereich zumindest einer Wandung des wannenförmigen Bereichs angeordnet oder durch zumindest eine Wandung ausgebildet. Das zumindest eine Festlager kann bei der Herstellung des zweiten Bauteils, das beispielsweise durch einen Spritzvorgang geformt wird, bereitgestellt werden.

Das erste Gehäuseteil umfasst einen Kontaktbecher, in welchem das erste, extern kontaktierbare Ende des zumindest einen Kontaktstifts angeordnet ist.

Das zweite Bauteil ist gemäß einer Ausführungsform als MID-Bauteil oder als Quasi-MID-Bauteil ausgebildet. Im letzteren Fall ist es zweckmäßig, wenn das zweite Bauteil eine einseitig metallisierte flexible Folie umfasst, die mit einem Kunststoff, insbesondere Polyimid, umspritzt ist. Die flexible Folie wird auch als Flexfolie bezeichnet.

Das elektronische Bauelement umfasst in einer weiteren Ausführungsform einen Sensor, insbesondere zur Erfassung einer Beschleunigung oder eines Drucks, zur Verwendung in einem Kraftfahrzeug.

Ein erfindungsgemäßes Verfahren zur Herstellung eines elektronischen Bauelements mit einer elektronischen Schaltung zur Erfassung und/oder Verarbeitung von Daten umfasst die folgenden Schritte: Bereitstellen eines ersten Bauteils, welches zumindest einen Kontaktstift mit einem ersten, extern kontaktierbaren Ende und mit einem zweiten Ende umfasst, welches einen ersten Steckkontakt zur Herstellung einer elektrischen Verbindung zu der elektronischen Schaltung ausbildet, wobei der erste Steckkontakt gabelförmig mit zumindest zwei Schenkeln ausgebildet ist; Bereitstellen eines zweiten Bauteils, das die elektronische Schaltung und einen zweiten, zu dem ersten Steckkontakt komplementären Steckkontakt umfasst, welcher elektrisch mit der elektronischen Schaltung verbunden ist und in einem wannenförmigen Bereich des zweiten Bauteils von zumindest einem Festlager gehaltert wird; und Verbinden des ersten und des zweiten Bauteils, wobei der zweite Steckkontakt in einem Zwischenraum zwischen den zumindest zwei Schenkeln angeordnet und kraftschlüssig mit den Schenkeln verbunden wird, wenn das erste und zweite Bauteil miteinander verbunden werden.

Das erfindungsgemäße Verfahren weist die gleichen Vorteile auf, wie sie in Verbindung mit dem vorstehend beschriebenen elektronischen Bauelement erläutert wurden.

In einer zweckmäßigen Ausgestaltung umfasst die Bereitstellung des zweiten Bauteils die folgenden Schritte: Bereitstellen einer einseitig metallisierten flexiblen Folie; Umund/oder Hinterspritzen der Folie in einem Spritzwerkzeug, wobei ein in diesem Schritt hergestelltes Halbzeug einen wannenförmigen Bereich und zumindest ein Festlager umfasst; und Einpressen des zweiten Steckkontakts in das zumindest eine Festlager, so dass ein erster Abschnitt des zweiten Steckkontakts in dem wannenförmigen Bereich zum Liegen kommt und ein zweiter, freier Abschnitt zum Eingriff mit dem ersten Steckkontakt außerhalb des wannenförmigen Bereichs in einer Ausnehmung vorgesehen ist.

Dabei kann optional vorgesehen sein, die Folie vor dem Umund/oder Hinterspritzen optional in eine dreidimensionale Form zu bringen.

Gemäß einer weiteren Ausführungsform umfasst die Bereitstellung des zweiten Bauteils ferner die folgenden Schritte: Aufbringen von Lotpaste auf das zweite Bauteil; und Durchführen eines Lötvorganges, indem eine elektrische Verbindung zwischen dem zweiten Steckkontakt und einem Leiterzugabschnitt der Metallisierung auf der flexiblen Folie hergestellt wird. Das Durchführen des Lötvorganges dient lediglich der Herstellung eines zuverlässigen elektrischen Kontaktes zwischen dem Leiterzugabschnitt und dem zweiten Steckkontakt. Aufgrund der konstruktiven Ausgestaltung des erfindungsgemäßen Steckkontaktes wird die Lötverbindung von mechanischen Kräften freigehalten.

Nach dem Schritt des Aufbringens von Lotpaste wird gemäß einer weiteren Ausgestaltung zumindest ein elektronisches Bauelement auf das zweite Bauteil aufgebracht, um die elektronische Schaltung auszubilden.

Die Erfindung wird nachfolgend näher anhand der Zeichnungen erläutert. Es zeigen:
- Fig. 1: eine Querschnittsdarstellung eines erfindungsgemäßen elektronischen Bauelements mit einem ersten, als Kontaktstecker ausgebildeten Bauteil und einem zweiten, als Deckel ausgebildeten Bauteil, wobei das erste und zweite Bauteil miteinander verbunden sind,
- Fig. 2: eine vergrößerte Darstellung des in Fig. 1 mit X gekennzeichneten Teils,
- Fig. 3: eine Querschnittsansicht des ersten, als Kontaktstecker ausgebildeten Bauteils,
- Fig. 4: eine perspektivische, teilweise aufgeschnittene Ansicht des zweiten Bauteils,
- Fig. 5: einen vergrößerten Ausschnitt des in Fig. 4 mit A gekennzeichneten Ausschnitts,
- Fig. 6: eine perspektivische und teilweise aufgeschnittene Ansicht, aus der die Verbindung zwischen einem ersten Kontaktstecker des (nicht dargestellten) ersten Bauteils und einem zweiten Kontaktstecker des zweiten Bauteils hervorgeht, und
- Fig. 7: eine vergrößerte Ansicht eines zweiten Kontaktsteckers in einem zweiten Bauteil.

In den Figuren sind gleiche Merkmale mit gleichen Bezugszeichen gekennzeichnet.

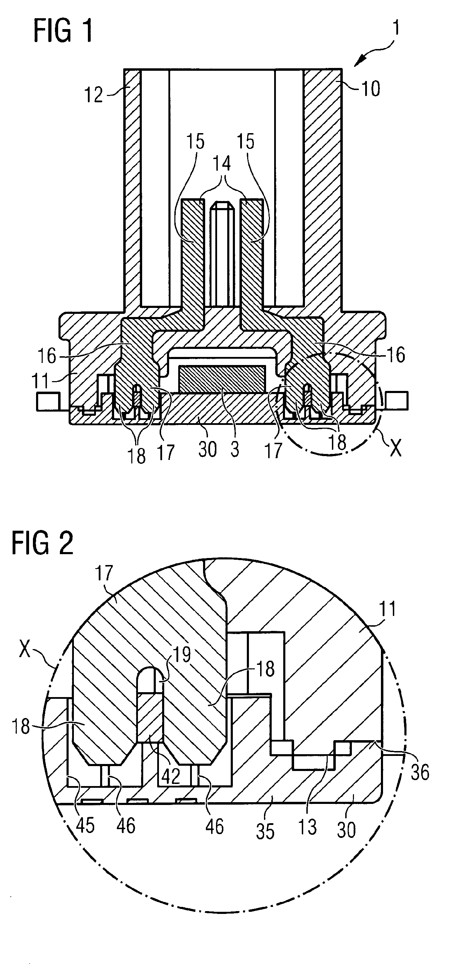

Fig. 1 zeigt in einer Querschnittsdarstellung ein erfindungsgemäßes elektronisches Bauelement 1. Das elektronische Bauelement 1 stellt beispielsweise ein Sensormodul für den Einsatz in Kraftfahrzeugen dar. Das elektronische Bauelement 1 wird beispielsweise als Seitenairbag-Satellit zur Erfassung eines Druckes oder Beschleunigung sowie zur Ansteuerung eines entsprechenden Rückhaltemittels verwendet.

Das elektronische Bauelement 1 ist im Wesentlichen zweiteilig ausgebildet. Ein erstes Bauteil 10 bildet einen Kontaktstecker aus, welcher mit einem Steckverbinder (nicht dargestellt) zur Übertragung von elektrischen Signalen an eine in der Figur nicht näher dargestellte Recheneinheit verbindbar ist. In einem zweiten Bauteil 30, welches im Wesentlichen eine elektronische Schaltung (in der Figur repräsentiert durch einen Sensor 2) zur Erfassung und/oder Verarbeitung von Daten umfasst, ist mit dem ersten Bauteil 10 elektrisch und mechanisch verbunden.

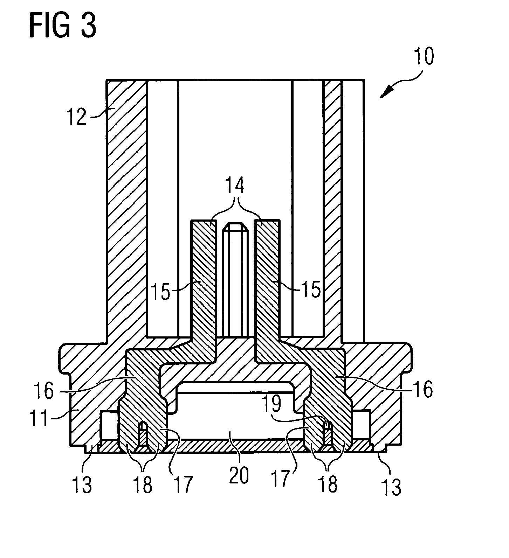

Die Ausgestaltung des ersten Bauteils 10 geht besser aus Fig. 3 hervor, in welcher dieses noch nicht mit dem zweiten Bauteil 30 verbunden ist. Das erste Bauteil 10 umfasst ein Gehäuse 11, welches beispielsweise aus einem Kunststoff, z.B. einem Thermoplast, hergestellt ist. An dem Gehäuse 11 ist ein Kontaktbecher 12 ausgebildet, welcher die korrespondierende Form zu einem Steckverbinder aufweist. Im Inneren des Kontaktbechers 12 erstrecken sich beispielhaft zwei Kontaktstifte 14, die mit ihren ersten Enden 15 mit korrespondierenden Kontakten des nicht dargestellten Steckerverbinders kontaktierbar sind. Zweite Enden 16 der Kontaktstifte 14, die den ersten Enden 15 gegenüberliegend angeordnet sind, stellen erste Steckkontakte 17 dar. Die Kontaktstifte 14 sind abschnittsweise, im Ausführungsbeispiel stufenförmig durch das Gehäuse 11 geführt, wobei die zweiten Enden 16 sich vom Boden des Gehäuses 11 in das Innere einer Kavität 20 erstrecken. Die Kavität 20 wird von einem Rand 13, der wulstartig ausgebildet ist, umlaufen. Die zweiten Enden 16 der Kontaktstifte 14 kommen in etwa in der Ebene des Randes 13 zum Liegen.

Wie aus Fig. 3 unschwer zu erkennen ist, weisen die zweiten Enden 16, die den ersten Steckkontakt 17 ausbilden, eine gabelförmige Gestalt mit jeweils zwei Schenkeln 18 auf. Zwischen den beiden Schenkeln 18 ist ein Zwischenraum 19 gebildet. Wie aus Fig. 2 besser hervorgeht, die das in Fig. 1 mit X gekennzeichnete Detail vergrößert darstellt, ragt ein zweiter Steckkontakt 42, der an dem zweiten Bauteil 30 ausgebildet ist, in den Zwischenraum 19 hinein, wenn das erste und das zweite Bauteil 10, 30 miteinander verbunden sind.

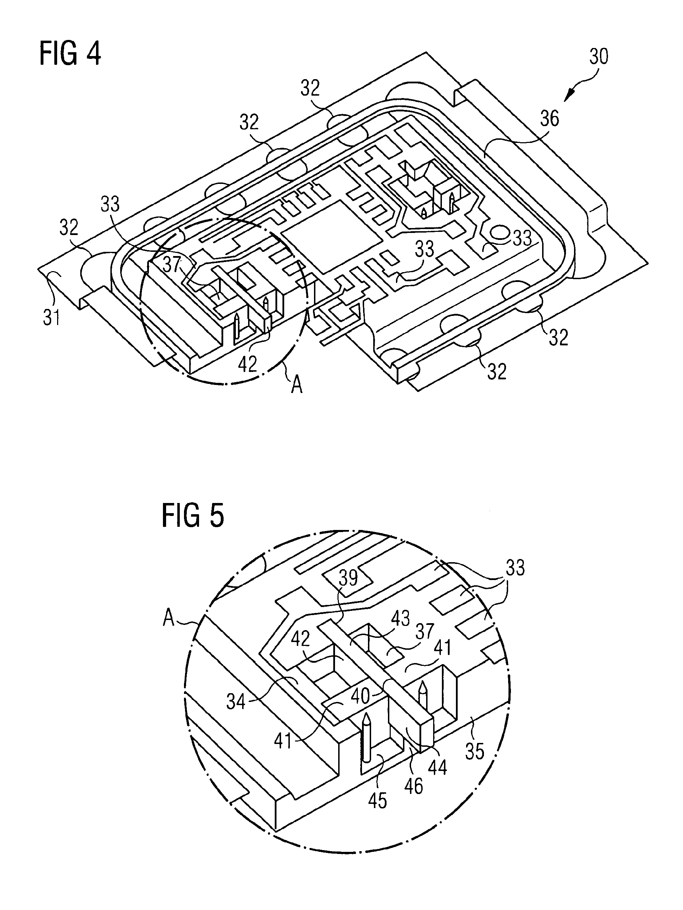

Die Ausgestaltung des zweiten Bauteils wird besser aus den Figuren 4 und 5 deutlich.

Das zweite Bauteil 30 ist im Ausführungsbeispiel als sog. Quasi-MID-Bauteil ausgebildet. Es verfügt über eine flexible Folie, die nachfolgend als Flexfolie 31 bezeichnet wird. Auf die Flexfolie 31 ist einseitig eine Metallisierung 33 aufgebracht. Die Metallisierung 33 ist in bekannter Weise in Form von Leiterzügen oder leitenden Flächen ausgebildet und dient zur elektrischen Verbindung der in dem zweiten Bauteil 30 auszubildenden elektronischen Schaltung. Die Flexfolie 31 ist in bekannter Weise mit Ausnehmungen bzw. Stanzungen 32 versehen. In der perspektivischen und teilweise aufgeschnittenen Darstellung der Fig. 4 ist die Flexfolie 31, z.B. aus Polyimid, in einer dreidimensionalen Form verformt ausgebildet und mit einem Kunststoff, bevorzugt einem Thermoplasten, um- bzw. hinterspritzt. Dabei sind einerseits ein unlaufender Rand 36 ausgebildet, der zur späteren mechanischen Verbindung mit dem ersten Bauteil 10 dient und ein wannenförmiger Bereich 37 ausgebildet, in den sich zumindest teilweise ein Leiterzugabschnitt 34 der Metallisierung 33 hineinerstreckt. Der wannenförmige Bereich 37 ist mit einer Nut 39 sowie einem Durchbruch 40 in einer Wandung 41, welche der Wandung mit der Nut 39 gegenüber liegt, versehen. Die Nut 39 und der Durchbruch 40 bilden zwei Festlager für den zweiten Steckkontakt 42 aus, der in der in Fig. 5 gezeigten Weise in die Nut 39 eingreift und durch den Durchbruch 40 in der Wandung 41 hindurch tritt. Dabei schließt der zweite Steckkontakt 42 in etwa bündig mit der Oberseite des zweiten Bauteils 30 ab.

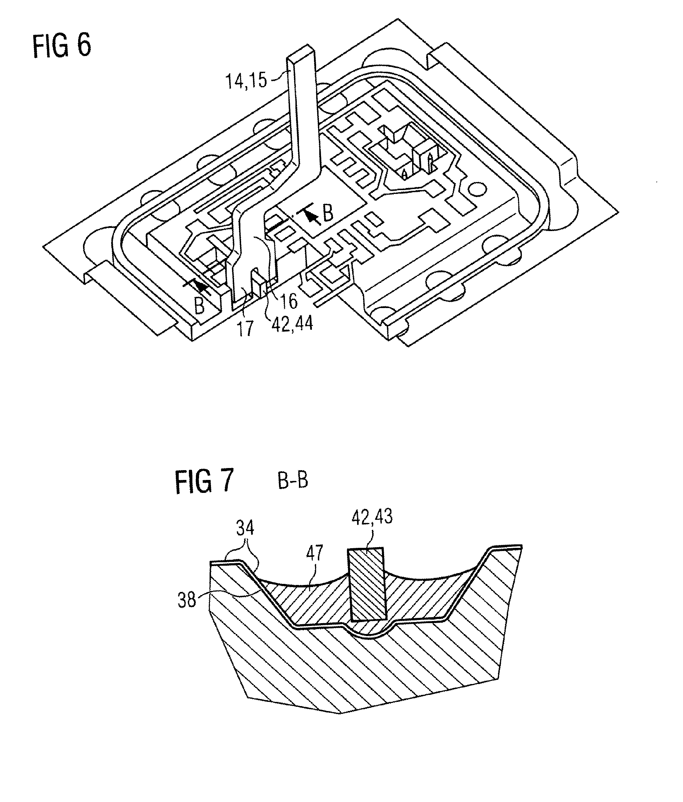

Durch die in Fig. 5 gezeigte kraftschlüssige Verbindung des zweiten Steckkontakts 42 an dem Gehäuse 35 des zweiten Bauteils 30 ist der zweite Steckkontakt 42 in einen ersten Abschnitt 43 und einen zweiten, freien Abschnitt 44 unterteilt. Der erste Abschnitt 43 kommt dabei in dem wannenförmigen Bereich 37 zum Liegen. Wie aus Fig. 7 besonders gut hervorgeht, wird der wannenförmige Bereich 37 mit einer Lotpaste 47 gefüllt, so dass eine elektrische Verbindung zwischen dem ersten Abschnitt 43 des zweiten Steckkontakts 42 und dem Leiterzugabschnitt 34 der sich von der Oberseite des Gehäuses entlang einer Flanke 38 in den wannenförmigen Bereich 37 hinein erstreckt, gebildet. Der zweite, freie Abschnitt 44 ist nach Art eines "Kragbalkens" ausgebildet, wobei die Lagerung _{"}des Kragbalkens" im Bereich bzw. durch das Festlager 40 erfolgt. Lediglich zur mechanischen Stützung und Stabilisierung liegt der zweite Steckkontakt 42 mit seinem zweiten Abschnitt 44 auf einem Auflager auf (vgl. Fig. 2 bzw. 5). Der zweite, freie Abschnitt 44 des zweiten Steckkontakts 42 ragt dabei in eine Ausnehmung 45 des zweiten Bauteils 30. Im Gegensatz zu dem wannenförmigen Bereich 37 wird die Ausnehmung 45 von Lot freigehalten. Eine mechanische, kraftschlüssige Verbindung zwischen dem ersten Steckkontakt 17 und dem zweiten Steckkontakt 42, wie dies im Querschnitt in Fig. 2 dargestellt ist, erfolgt dabei im Bereich des zweiten, freien Abschnitts 44. Hierdurch wird sichergestellt, dass auf die Lötverbindung im Bereich es ersten Abschnitts 43 keine mechanische Kraft ausgeübt wird, was mechanischen Defekten vorbeugt.

Aufgrund der geometrischen Ausgestaltung des Zwischenraums 19 und der Querschnittsform und den Abmessungen des zweiten Steckkontakts 42 erfolgt eine kraftschlüssige Verbindung zwischen den Verbindungspartnern, die zudem gasdicht ist. Die konstruktive Ausgestaltung der Steckverbindung erlaubt es, das erste und zweite Bauteil 10, 30 blind miteinander zu verbinden. Sofern des erste und das zweite Bauteil 10, 30 relativ zueinander korrekt positioniert sind, ergibt sich aus der vorgeschlagenen Steckverbindung automatisch der gewünschte, zuverlässige elektrische Kontakt.

Eine mechanische Verbindung zwischen dem ersten und dem zweiten Bauteil 10, 30 erfolgt im Bereich des Rahmens 13 bzw. 36. Die Verbindung wird bevorzugt durch eine Schweißung hergestellt, wobei insbesondere eine Laserschweißung bevorzugt ist.

Aus Fig. 6 wird nochmals in einer perspektivischen Ansicht die Verbindung des ersten Steckkontakts 17 mit dem zweiten Steckkontakt 42 ersichtlich. Insbesondere ist aus dieser Darstellung gut zu erkennen, dass die Verbindung im Bereich des zweiten, freien Abschnitts 44 erfolgt.

Als weiterer Vorteil der erfindungsgemäßen Steckverbindung ist die einfache und kostengünstige Fertigung zu nennen. Die Art der beschriebenen Steckverbindung erlaubt eine lediglich einseitige Metallisierung der Flexfolie 31. Dies resultiert daraus, dass die zweiten Enden 16 der Kontaktstifte 14 nicht durch Durchtrittsöffnungen der Flexfolie gesteckt werden müssen, um einen Lötvorgang von der Außenseite her zu ermöglichen. Das Aufbringen der Lotpaste 47 in den wannenförmigen Bereich 37 kann gleichzeitig mit dem Aufbringen der Lotpaste auf die Metallisierung 33 erfolgen. Es ist lediglich sicherzustellen, dass das Einpressen des zweiten Steckkontakts 42 in den wannenförmigen Bereich 37 (im Ausführungsbeispiel in die Nut 39 sowie den Durchbruch 40 in der Wandung 41) vor dem Aufbringen der Lotpaste erfolgt. Damit ergibt sich als einziger zusätzlicher Schritt zu den bekannten und erprobten Herstellungsschritten das Einbringen bzw. -pressen des zweiten Steckkontakts in dem dafür vorgesehenen Bereich.

## Patentansprüche

1. Elektronisches Bauelement (1) mit einer elektronischen Schaltung zur Erfassung und/oder Verarbeitung von Daten, wobei das elektronische Bauelement (1) umfasst:
- ein erstes Bauteil (10), welches zumindest einen Kontaktstift (14) mit einem ersten, extern kontaktierbaren Ende (15) und einem zweiten Ende (16) umfasst, welches einen ersten Steckkontakt (17) zur Herstellung einer elektrischen Verbindung zu der elektronischen Schaltung ausbildet,
- ein zweites Bauteil (30), das die elektronische Schaltung und einen zweiten, zu dem ersten Steckkontakt (17) komplementären Steckkontakt (42) umfasst, welcher elektrisch mit der elektronischen Schaltung verbunden ist und in einem wannenförmigen Bereich (37, 45) des zweiten Bauteils (30) von zumindest einem Festlager (39, 40) gehaltert wird,
- wobei der erste Steckkontakt (17) gabelförmig mit zumindest zwei Schenkeln (18) ausgebildet ist, so dass der zweite Steckkontakt (42) in einem Zwischenraum (19) zwischen den zumindest zwei Schenkeln (18) angeordnet und kraftschlüssig mit den zumindest zwei Schenkeln (18) verbunden ist, wenn das erste und zweite Bauteil (10, 30) miteinander verbunden sind.

2. Bauelement (1) nach Anspruch 1, bei dem der zweite Steckkontakt (42) kraftschlüssig von dem zumindest einen Festlager (39, 40) gehaltert wird.

3. Bauelement (1) nach Anspruch 1 oder 2, bei dem der zweite Steckkontakt (42) von zwei Festlagern (39, 40) gehaltert wird.

4. Bauelement (1) nach einem der vorherigen Ansprüche, bei dem ein erster Abschnitt (43) des zweiten Steckkontakts (42) in dem wannenförmigen Bereich (37, 45) angeordnet ist, welcher mit einer Lotpaste (47) gefüllt ist, um eine elektrische Verbindung zwischen dem zweiten Steckkontakt (42) und einem Leiterzugabschnitt (34) herzustellen, welcher sich in den wannenförmigen Bereich (37, 45) hinein erstreckt.

5. Bauelement (1) nach Anspruch 4, bei dem ein zweiter, freier Abschnitt des zweiten Steckkontakts (42) durch das zumindest eine Festlager (39, 40) und ein Ende des zweiten Steckkontakts (42) begrenzt wird, wobei ein Eingriff des gabelförmigen, ersten Steckkontakts (17) mit dem zweiten Steckkontakt (42) in dem zweiten Abschnitt (44) in einer Ausnehmung (45) des zweiten Bauteils (30) erfolgt.

6. Bauelement (1) nach einem der vorherigen Ansprüche, bei dem das zumindest eine Festlager (39, 40) im Bereich zumindest einer Wandung des wannenförmigen Bereichs angeordnet ist oder durch die zumindest eine Wandung ausgebildet ist.

7. Bauelement (1) nach einem der vorherigen Ansprüche, bei dem das erste Gehäuseteil einen Kontaktbecher umfasst, in welchem das erste, extern kontaktierbare Ende des zumindest einen Kontaktstifts (14) angeordnet ist.

8. Bauelement (1) nach einem der Ansprüche 1 bis 7, bei dem das zweite Bauteil (30) als MID-Bauteil ausgebildet ist.

9. Bauelement (1) nach einem der Ansprüche 1 bis 7, bei dem das zweite Bauteil (30) als Quasi-MID-Bauteil ausgebildet ist.

10. Bauelement (1) nach Anspruch 9, bei dem das zweite Bauteil (30) eine einseitig metallisierte flexible Folie (31) umfasst, die mit einem Kunststoff, insbesondere Polyimid, umspritzt ist.

11. Bauelement (1) nach einem der vorherigen Ansprüche, bei dem das elektronische Bauelement (1) einen Sensor, insbesondere zur Erfassung einer Beschleunigung oder eines Drucks, zur Verwendung in einem Kraftfahrzeug umfasst.

12. Verfahren zur Herstellung eines elektronischen Bauelements (1) mit einer elektronischen Schaltung zur Erfassung und/oder Verarbeitung von Daten, mit den Schritten:
- Bereitstellen eines ersten Bauteils (10), welches zumindest einen Kontaktstift (14) mit einem ersten, extern kontaktierbaren Ende (15) und einem zweiten Ende (16) umfasst, welches einen ersten Steckkontakt (17) zur Herstellung einer elektrischen Verbindung zu der elektronischen Schaltung ausbildet, wobei der erste Steckkontakt (17) gabelförmig mit zumindest zwei Schenkeln (18) ausgebildet ist;
- Bereitstellen eines zweiten Bauteils (30), das die elektronische Schaltung und einen zweiten, zu dem ersten Steckkontakt (17) komplementären Steckkontakt (42) umfasst, welcher elektrisch mit der elektronischen Schaltung verbunden ist und in einem wannenförmigen Bereich des zweiten Bauteils (30) von zumindest einem Festlager (39, 40) gehaltert wird; und
- Verbinden des ersten und des zweiten Bauteils (30), wobei der zweite Steckkontakt (42) in einem Zwischenraum (19) zwischen den zumindest zwei Schenkeln (18) angeordnet und kraftschlüssig mit den Schenkeln (18) verbunden wird, wenn das erste und zweite Bauteil (10, 30) miteinander verbunden werden.

13. Verfahren nach Anspruch 12, bei dem die Bereitstellung des zweiten Bauteils (30) die folgenden Schritte umfasst:
- Bereitstellen einer einseitig metallisierten flexiblen Folie (31);
- Um- und/oder Hinterspritzen der Folie (31) in einem Spritzwerkzeug, wobei ein in diesem Schritt hergestelltes Halbzeug einen wannenförmigen Bereich (37, 45) und zumindest ein Festlager (39, 40) umfasst; und
- Einpressen des zweiten Steckkontakts (42) in das zumindest eine Festlager (39, 40), so dass ein erster Abschnitt (43) des zweiten Steckkontakts (42) in dem wannenförmigen Bereich (37)zum Liegen kommt und ein zweiter, freier Abschnitt zum Eingriff mit dem ersten Steckkontakt (17) außerhalb des wannenförmigen Bereichs in einer Ausnehmung (45) vorgesehen ist.

14. Verfahren nach Anspruch 13, bei dem die Folie (31) vor dem Um- und/oder Hinterspritzen optional in eine dreidimensionale Form gebracht wird.

15. Verfahren nach Anspruch 13 oder 14, bei dem die Bereitstellung des zweiten Bauteils (30) ferner die folgenden Schritte umfasst:
- Aufbringen von Lotpaste (47) auf das zweite Bauteil (30); und
- Durchführen eines Lötvorganges, in dem eine elektrische Verbindung zwischen dem zweiten Steckkontakt (42) und einem Leiterzugabschnitt (34) der Metallisierung auf der flexiblen Folie (31) hergestellt wird.

16. Verfahren nach Anspruch 15, bei dem nach dem Schritt des Aufbringens von Lotpaste (47) zumindest ein elektronisches Bauelement auf das zweite Bauteil aufgebracht wird.
